# EUROPEAN PATENT APPLICATION

(11) **EP 4 455 358 A1**
(43) Date of publication of application: **30.10.2024**
(21) Application number: 23170741.5
(22) Date of filing: 28.04.2023
(51) Int. Cl.: C23C 14/50

(54) **DEVICE FOR TURNING LENSES IN A COATING APPARATUS AND METHOD FOR PRODUCING A SPECTACLE LENS**

(71) Applicant: Carl Zeiss Vision International GmbH, 73430 Aalen (DE)
(72) Inventor: ELLENRIEDER, Marc, 73431 Aalen (DE); SCHAMBECK, Andreas, 73431 Aalen (DE); KOEPPEL, Julia, 73479 Ellwangen (DE); FRIEDL, Alexander, 73434 Aalen (DE); KOENEN, Timo, 73566 Bartholomä (DE); MACIONCZYK, Frank, 73447 Oberkochen (DE)
(74) Representative: Carl Zeiss AG - Patentabteilung

(57) **Abstract**

The invention relates to a device (200) for turning spectacle lenses (101) in a coating apparatus (100), comprising a carrier (105) which is rotatably mounted about a axis of rotation (107) and on which a plurality of lens holders (109) are arranged on concentric wreaths (112) of different diameters in order to hold the spectacle lenses (101) to be coated, wherein the lens holders (109) are mounted such that they can be turned about a pivot axis (110) by means of a magnetic force generated by a magnetic field generator (113). The magnetic field generator (113) is configured such that the magnetic field (117) generated by the magnetic field generator (113) is substantially constant over at least two adjacent wreath (112).

## Description

The invention relates to a device for turning spectacle lenses in a coating apparatus, comprising a carrier, exhibiting a calotte shaped form, which is rotatably mounted about an axis of rotation, the axis of rotation forming the symmetry axis of the carrier. On the carrier, a plurality of lens holders are arranged on concentric wreaths of different diameters in order to hold the spectacle lenses to be coated. The lens holders are mounted in openings of the carrier such that the lens holders can be turned about a pivot axis by means of a magnetic force generated by a magnetic field generator. Furthermore, the invention relates to a method for producing a spectacle lens.

Spectacle lenses, or other ophthalmic lenses, are often subject to a coating process during their manufacturing process. In some cases, for example, an anti-reflection coating may be applied to the spectacle lens substrates to improve the optical properties of the final spectacle lenses. These anti-reflection coatings, but also other functional coatings, are produced in a coating apparatus, or coating system, usually under vacuum conditions or under high-vacuum conditions. The spectacle lenses to be coated are releasably mounted on the calotte shaped carrier in individual lens holders by applying a clamping force or by other suitable methods such that one side of the spectacle lens faces the evaporator or sputter source. The lens holders are usually inserted into recesses or openings provided for this purpose in the carrier. The carrier might be segmented and may consist of three or four segments. The segmentation of the carrier facilitates the handling of the spectacle lenses, as the segments can be individually removed from the vacuum chamber of the coating apparatus to load and unload the spectacle lens to the carrier or to the lens holders before or after the coating process. The carrier can be rotated about the axis of symmetry, i.e. the axis of rotation, of the calotte by means of a motor-driven rotation device. The lens holders are arranged on the calotte on concentric wreaths or concentric rings in order to arrange as many lenses as possible on the carrier. Due to the arrangement of the spectacle lenses on concentric wreaths or rings, all the spectacle lenses face the evaporation source and each of the spectacle lenses has the same distance from the evaporation source, which provides homogenous evaporation conditions and thus homogenous coating results. However, as only one side of the spectacle lenses mounted on the carrier, i.e. that side of the spectacle lens which faces the evaporation source, can be coated by the coating apparatus there is the need to open the vacuum chamber during the coating process in order to take the carrier or its segments out of the vacuum chamber and to manually turn the individual lenses in order to be able to coat also the second side of the spectacle lenses in the further coating process. Mounting the spectacle lenses with individual lens holders on a calotte shaped carrier, which is then inserted into a coating device to arrange the substrates at a predetermined position and in a predetermined orientation with respect to a particle or evaporation source in the coating system are for example described in WO 2022/012955 A1 and WO 2004/108977 A2.

However, it has proved disadvantageous that the turning of the spectacle lenses and/or the lens holders on the calotte shaped carrier has to be done manually. In addition, this can only be done with the an open vacuum chamber, so the coating device must first be vented so that the operator can open the vacuum chamber and remove the segments of the carrier or the carrier itself from the vacuum chamber to manually turn over or flip the spectacle lenses in the respective holder. After the flipping, the chamber must be pumped out again to generate the required high-vacuum inside the vacuum chamber before the second side of the spectacle lenses can be coated. This, however, is rather time consuming, which is disadvantageous for an efficient coating process and the overall production process of the spectacle lenses.

To reduce this manual effort, the DE 102006041137 B4, which is considered closest prior art for the present invention, discloses a method and device for turning the spectacle lenses mounted on the lens holders on the carrier without having to remove them from the lens holders and, in particular, without having to open the vacuum chamber. The core idea of the DE 102006041137 B4 is that the entire lens holder is tiltable or turnable around a pivot axis by 180°. The tilting takes place by means of an interaction between a magnetic field of a magnetic field generator in the form of an electromagnet comprising a coil and a ferromagnetic part of the lens holder. While the calotte shaped carrier is rotated around the axis of rotation the magnetic field generator interacts with the ferromagnetic part of the lens holder being positioned below the magnetic field generator resulting in a magnetic force sufficient to turn the respective lens holder, which is further described in DE 102006041137 B4, which content is herewith fully incorporated. By means of this, the lens holder together with the spectacle lens mounted therein are turned in such a way that the side of the spectacle lens that has not yet been coated now points in the direction of the evaporation source. In the DE 102006041137 B4, the lens holders are also arranged on concentric wreath or concentric rings.

Specifically, in the coating device described in the DE 102006041137 B4, the lens holders are arranged on two concentric wreaths or rings. For turning the lens holders and the corresponding spectacle lenses of each wreath in total two magnetic field generators are provided, each of them being assigned to the lens holders of a single wreath. These magnetic field generators are positioned in the vacuum chamber in a way that the lens holders are automatically turned when the calotte shaped carrier is rotated about the axis of rotation below the magnetic field generator. The magnetic field generators can be turned on and off to prevent an unintentional turning of the spectacle lenses.

For calotte shaped carriers, in which the lens holders are arranged in two concentric wreaths, each with a dedicated magnetic field generator, the prior art turning device has proven itself to be quite useful. Since each concentric wreath is assigned its own magnetic field generator, which is arranged directly above the assigned wreath or ring, the solution known from the prior art can ensure that indeed each lens holder - and the spectacle lens mounted therein - of the corresponding wreath can be safely turned when the calotte shaped carrier is rotated. However, if the number of spectacle lenses to be coated in a single coating process is to be increased, the solution known from the prior art reaches its limits. If the number of spectacle lenses is increased, the number of concentric wreaths must ultimately also be increased in order to be able to place all the spectacle lenses to be coated on the calotte shaped carrier.

In a further development of the device known from the DE 102006041137 B4, an attempt was therefore made to successively increase the number of wreaths on the calotte shaped carrier in order to be able to coat a larger number of spectacle lenses in a single coating step and to increase also the number of magnetic field generators. However, due to the limited space within the vacuum chamber aligning the number of magnetic field generators to the number of wreath, in which the lens holder had been arranged, was not possible. This lead to the problem that not all lens holders and corresponding spectacle lenses are turned on all concentric wreaths. This in turn results in a situation, where sometimes one side of some of the spectacle lenses was coated twice while the other side of the respective spectacle lens was not coated at all. This results in an increased workload for identifying the twice coated lenses - in a first step - after the coating process. In a subsequent step, the double coating must then be removed, and the spectacle lens must be recoated or the spectacle lens in question must be disposed and completely remanufactured.

The problem, thus, relates to providing a device, which reduces the problems mentioned below and which ensures safe turning of the spectacle lenses mounted in the lens holders.

This problem is solved according to the invention by a device for turning lenses in a coating apparatus and by a method for producing a spectacle lens having the features of the independent claims. Preferred embodiments, which may be implemented in an isolated fashion or in any arbitrary combination, are listed in the dependent claims or throughout the following description.

In a first aspect, the invention relates to a device for turning spectacle lenses in a coating apparatus, comprising a carrier which is rotatably mounted about an axis of rotation and on which a plurality of lens holders are arranged on concentric wreaths of different diameters in order to hold the lenses to be coated, wherein the lens holders are mounted such that they can be turned about a pivot axis by means of a magnetic force generated by a magnetic field generator. According to the invention the magnetic field generator is configured such that the magnetic field generated by the magnetic field generator is substantially constant over at least two adjacent wreaths.

In a second aspect, the invention relates to a method for producing a spectacle lens, which comprises step of:
- Turning the spectacle lens mounted in one of a multiple of lens holders a spectacle lens holders arranged in concentric wreaths of different diameters on a carrier of a coating apparatus by means of a magnetic force generated by a magnetic field generator; wherein the magnetic field generator generates a magnetic field, which the is substantially constant over at least two adjacent wreaths.

As generally used, the term "ophthalmic lens" refers to a lens body which comprises a particular shape that is configured for a purpose of measurement, correction and/or protection of the eye, or for changing its appearance and which is altering a vision of a wearer of the ophthalmic lens. Based on standard ISO 13666:2019, also herein referred to as "Standard", 3.5.2, the term "spectacle lens" refers to a particular kind of ophthalmic lens which is used for determining and/or altering the vision of the wearer of the spectacle lens, wherein the spectacle lens is carried in front of the eye of a wearer, thereby avoiding a direct contact with the eye of a wearer. Instead of the term "wearer", a different term, such as "person" or "subject", may also be applicable. The "spectacle lens" may be either a "blank", i.e. according to 3.8.1 of ISO 13666:2019 a piece of optical material with one optically finished surface for the making of a spectacle lens, a "finished lens", i.e. according to 3.8.7 of ISO 13666:2019 a spectacle lens of which both sides have their final optical surface, an uncut lens, i.e. according to 3.8.8 ISO 13666:2019 a finished lens prior to edging , or an edged lens, i.e. according to 3.8.9 of ISO 13666:2019 a finished lens edged to the final size and shape.

As further generally used, the term "side" of a spectacle lens denotes either the "front surface", i.e. according to 3.2.13 of ISO 13666:2019 the surface of the spectacle lens intended to be fitted away from the eye, or the "back surface", i.e. according to 3.2.14 of ISO 13666:2019 the surface of the spectacle lens intended to be fitted nearer to the eye.

As generally used, the terms "turning" or "flipping", which are interchangeable used herein, or any grammatical variation thereof, refers to rotating the spectacle lenses by around 180° around an axis which is essentially perpendicular to a normal of one of the sides of the spectacle lens. Therefore, after turning the spectacle lens the side of the spectacle lens, which initially faced the evaporation source faces thereafter away from it.

As generally used, the term "coating apparatus", "coating system", or "coating device" or any variations thereof refers to a device by means of which optically active materials can be evaporated or sublimated from an evaporator source or sputtered from a sputter source under preferably at least high vacuum conditions and deposited on the spectacle lenses. All the expressions "coating apparatus", "coating system", or "coating device" are synonyms and can be used interchangeably. As further generally used, the term "evaporation source" refers to the actual material source of the coating apparatus, in which the optically active material is stored and evaporated or sublimated from. It should be noted that the term "evaporation" refers to all forms of material deposition, including also sputtering and sublimation.

As generally used, the term "carrier" refers to a structure on which the spectacle lenses to be coated are arranged. As described already above, the carrier exhibits a calotte or dome formed shape and might consist in a preferred embodiment of several segments, most preferably in total of four segments, which can be removed individually from the coating apparatus to load and unload the spectacle lenses before and after the coating. As generally used, the carrier being "calotte shaped" refers to fact that the shape of the carrier follows the shape of a calotte. Hence, the carrier may be domed, wherein the dome may have the shape of a half sphere or any other portion of a sphere having the shape of a spherical cap or spherical dome. The calotte shaped carrier may have the appearance of a spherical cap but may deviate from the strict mathematical shape of a spherical cap. The calotte shaped carrier may be rotationally symmetric around the central axis, wherein the central axis may form a central axis of a sphere defining the calotte or spherical cap describing the shape of the carrier. The calotte shape of the carrier may have a radius of curvature in the range from 0.5 m to 2 m and in particular a radius of curvature in the range from 0.5 m to 1 m, i.e., the sphere describing the shape of the calotte holder may have a radius of curvature in the range from 0.5 m to 2 m and in particular a radius of curvature in the range from 0.5 m to 1.2 m or 0.8 m to 1.2 m. In case the radius of curvature varies for different altitudinal positions of the calotte shaped, the radius of curvature may be in the specified range at any position. In other words, any radius of curvature which the calotte shaped carrier exhibits may be well in the specified range.

As generally used, the term "lens holder" refers to a structure on the carrier in which the spectacle lens is mounted by the operator. The lens holders might consist of a clamping structure, which holds the spectacle lenses by means of a clamping force, for example by using springs which are in radial contact with the spectacle lenses. However, the lens holders may also be constructed in other ways, as long as they provide for an easy mounting and dismounting of the spectacle lens. The lens holders themselves are turnable mounted on the carrier around a pivot axis in order to allow for a turning of the respective spectacle lenses mounted therein. The motion of the lens holders around the pivot axis is limited to preferably 180°. The lens holders comprise each a magnetic or ferromagnetic part, allowing for turning the lens holders and the spectacle lens mounted therein.

As generally used, the term "concentric wreath" refers to the arrangement of the lens holders and the spectacle lenses mounted therein. Each lens holder assigned to a specific individual wreath exhibit essentially the same distance to the symmetric axis of the carrier, i.e. its axis of rotation as the other lens holder on the same wreath. Therefore, "concentric ring" might be used as a synonym for the expression "concentric wreath".

As generally used, the term "magnetic field generator" refers to a device which generates a magnetic field, either permanently, for example in the case of permanent magnets, or upon the application of an electric current, as for example in the case of electromagnets. The magnetic field generator might consist of several individual magnets, which are however arranged as a single piece acting as a unit. As further generally used, the term "substantially constant over at least two adjacent wreaths" refers to a magnetic field which exhibit a spatial extension ranging over at least two adjacent wreaths without significant deviations therein.

By applying a substantially constant magnetic field to the lens holders of adjacent wreaths or rings, it can be ensured that all spectacle lenses mounted in lens holders of adjacent wreaths can also be reliably turned. As mentioned above, in the context of the invention a substantially constant magnetic field means that small deviations in the field are covered by the expression. However, it is meant that the magnetic field is not only assigned to a certain wreath of lens holders, but has a spatial extension ranging over at least two adjacent wreaths of lens holders. In other words, the resulting magnetic field of the magnetic field generator extends over several - at least two - wreaths of the carrier, exhibiting a constant field. By means of this, a single magnetic field generator can ultimately be used to reliably turn the lens holders of adjacent wreaths without having the need to assign a single magnetic field generator to a single wreath. Within the scope of the invention, however, it is also envisaged that - although the magnetic field is constant over adjacent wreath, the resulting magnetic force applied to a wreath with a small diameter is higher than the magnetic force applied to a wreath with a larger diameter. This takes into consideration that, due to the arrangement of the lens holders on the calotte shaped carrier, the lens holders that are arranged on a wreath with a larger diameter ultimately stand more steeply, so that the gravitational force to be compensated by the magnetic force in order to turn the lens holders and the corresponding spectacle lenses is ultimately smaller than for lens holders that are arranged on a wreath with a smaller diameter.

In this context, it has proved useful if the value of the resulting magnetic force applied to the spectacle lens holders is between 0.001 N and 0.025 N. This ensures that the force is sufficient for turning the lens holders and the spectacle lenses mounted therein. As mentioned above, the magnetic force that must be applied to turn a spectacle lens mounted in the respective lens holder is ultimately highly dependent on the position of the wreath on the carrier and hence on the gravitational force to be compensated. Since the individual lens holders are arranged on the calotte shaped carrier, the magnetic force to be applied varies from wreath to wreath. In addition to the position of the lens holder on the calotte or dome shaped carrier, the gravitational force to be compensated also depends on the size and thickness of the lens to be coated. In a preferred embodiment, in which the lens holders are arranged in five wreaths in total, for the wreath with the smallest diameter, generally referred to as "first wreath", which is located at the top of the carrier, the required force to turn the lens holders together with the associated spectacle lens will the highest with up to 0.025 N and for the wreath with the largest diameter - generally referred to as "fifth wreath" - the required force to turn the lens holders will be the smallest with only about up to 0.001 N.

It has also proved useful if the shape of the magnetic field generator is adapted to the shape of the carrier. As generally used, the term "a shape being adapted to another shape" or any grammatical variation thereof refers to a shape that follows at least partly the other shape, meaning that both shapes exhibit the same or similar curvature or having a constant distance. However, within the scope of the invention also a linear or straight shape of the magnetic field generator is considered as "being adapted" to a, for example, curved shape of the carrier. In this case the magnetic field generator can be regarded as a tangent to the carrier. This is a simple way to ensure that the distance between the magnetic field generator and the carrier is essentially constant. However, the distance between the magnetic field generator and the carrier must be dimensioned in such a way that the lens holders can be turned about the pivot axis without colliding with the magnetic field generator. In particular, it is also provided in the context of the invention that the magnetic field generator has an elongated but curved shape that exactly follows the calotte formed shape of the carrier. By adapting the external shape of the magnetic field generator to the shape of the carrier, it can be ensured in a particularly simple manner that the resulting force applied to the lens holders of the individual wreaths of the carrier is essentially constant, thus reducing the risk that not all glasses are turned. Alternatively, within the scope of the invention and as described above, the "adaptation of the shape of the magnetic field generator to the shape of the carrier" also covers a magnetic field generator, which has an uncurved, elongated straight shape. In this case the magnetic field generator can be preferably arranged in a way that it will be closer to a wreath with a smaller diameter than compared to a wreath with a lager diameter. Such a shape of the magnetic field generator facilitates the construction of the magnetic field generator. In addition, such a straight shape and the arrangement described above takes also into account, that for spectacle lenses arranged on a wreath with a smaller diameter the required magnetic force for turning theses spectacle lenses will be larger compared to spectacle lenses which are arranged on a wreath with a larger diameter. Due to the smaller distance of the magnetic field generator to wreaths with smaller diameters, the resulting magnetic force will be larger for the lens holders and the corresponding spectacle lenses arranged at these wreaths as compared with wreaths having a lager diameter, for which also the distance between the magnetic field generator and the lens holders will we larger, resulting in a lower magnetic force, which is applied in said lens holders arranged on said wreaths having a larger diameter.

It is also favorable if the magnetic field generator has a shape such that the magnetic field generator extends over at least two of the concentric wraths. In particular, by using a single magnetic field generator that covers several concentric wraths, it can be ensured that the magnetic field at lens holders of two adjacent wraths is essentially constant. In a preferred embodiment the magnetic field generator exhibits an elongated straight shape, with a longitudinal axis, which preferably lies in a plane defined by a cross-section through the calotte shaped carrier that includes the axis of rotation. Within the scope of the invention, it is in particular also preferable here that only a single magnetic field generator is used, which extends over at least two, preferably over all, wreath or rings. Within the scope of the invention, however, it is also envisaged that the magnetic field generator is arranged over two adjacent rings, only. In this case more than one magnetic field generator is provided.

It has proven to be particularly advantageous if the magnetic field generator comprises a Halbach array. By using a Halbach array, a directional magnetic field can be provided. As generally used, the term "Halbach array" refers to a distinct arrangement of the magnets that make up the Halbach array. More precisely, the magnets, which can be permanent magnets or electromagnets, have an alternating arrangement in which neighboring magnets are rotated by 90° to each other in the direction of the longitudinal axis of the magnetic field generator, i.e. the Halbach array. This results in the field lines strengthening or enhancing on one side of the Halbach array, while on the other side of the Halbach array the field lines partially cancel each other out. This arrangement thus ultimately results in a strong side and a weak side of the magnetic field generator and thus in a directed magnetic field. Such a directional magnetic field has the decisive advantage that the magnetic force is only induced in the lens holders and an adverse effect of the magnetic field to the surrounding of the vacuum chamber can be avoided without the need to provide a shielding of the magnetic field generator.

In this context, it has also proven advantageous if the Halbach array comprises a plurality of permanent magnets. The use of permanent magnets has proven to be particularly advantageous, as these can be easily arranged in an alternating manner to form the Halbach array described above. In this context, it has proved to be advantageous if the number of permanent magnets of the Halbach array of the magnetic field generator is between 3 and 21, preferably between 6 and 15 and particularly preferably between 9 and 12. Since in a Halbach array the individual permanent magnets are rotated 90° to each other in the direction of the longitudinal axis of the magnetic field generator, it is particularly advantageous if the permanent magnets have a substantially square cross-section. This then ensures that the Halbach array - regardless of the orientation of the permanent magnets - has a homogenous shape.

In a preferred embodiment and in accordance with the present invention the permanent magnets of the Halbach array are pivotable around a longitudinal axis of the magnetic field generator by at least 120°. Since the Halbach array ultimately generates a directional magnetic field, the magnetic field can be turned away from the lens holders by pivoting the Halbach array about the longitudinal axis. Ultimately, by doing this the magnetic force applied by the magnetic field generator to the lens holders acting can be switched "on" and "off". If the enhanced magnetic field of the magnetic field generator points towards the lens holder the magnetic force can be considered as being "on" and the lens holders can be turned. However, if the magnetic field generator is turned, the enhanced magnetic field faces away from the lens holders and the magnetic force can be considered as being "off" and the lens holders will not be turned. Here, it is particularly preferred within the scope of the invention that the pivoting of the magnetic field generator is effected by means of a mechanical and/or a motorized adjustment. In particular, the mechanical pivoting of the magnetic field generator can be actuated by means of a vacuum feedthrough from outside the device. In this case, it is also provided that the pivoting motion of the magnetic field generator can be limited between two limit positions, each of which is defined by a stop. Alternatively or additionally, however, it is also provided that the mechanical pivoting of the magnetic field generator is motor-assisted and, in particular, can be operated from outside the chamber. In the latter case, the motor might be arranged outside of the vacuum chamber. Also, an automated adjustment or pivoting movement of the magnetic field generator is provided. So, after all lens holders have been turned, the magnetic field generator will we pivoted, and the magnetic force is turned off.

In a further preferred embodiment, the Halbach array is formed of a plurality of electromagnets and is switchable between a first state generating the magnetic field and a second state in which the magnetic field generator is deactivated. Forming the Halbach array with a plurality of electromagnets requires a more elaborate design to generate the directional magnetic field compared to a Halbach array which consists of a plurality of permanent magnets as described above. However, using electromagnets facilitates the process of switching the magnetic field generator between the first state in which the electromagnets are on, i.e. generating the magnetic field, and a second state in which the electromagnets are off, i.e. in which the magnetic field is not generated. Also, here an automated switching between "on" and "off' might be provided after all the spectacle lenses mounted in the lens holders have been turned.

It has also been shown to be advantageous if the angle between the magnetic field generator and the axis of rotation is greater than 40°, preferably greater than 45°. As generally used, the "angle between the magnetic field generator and the axis of rotation" is defined by the angle between the longitudinal axis of the magnetic field generator and the axis of rotation, which generally applies for magnetic field generators exhibiting an elongated shape. Here it is pointed out once again that the magnetic field generator is arranged in such a way that the longitudinal axis of the magnetic field generator and the axis of rotation intersect, i.e. that both axis are in the same plane.

It has also proved useful if at least two magnetic field generators are provided. This is a simple way of ensuring that the shape of the magnetic field generator is adapted to the shape of the carrier even when using unbent, i.e. straight, magnetic field generators.

In order to prevent vapor deposition on the magnetic field generator, it has also proved advantageous if protection means for covering the magnetic field generator at least partly is provided. This protection means can be selected from a group comprising a shielding and a tubing. This means that the magnetic field generators can be additionally encapsulated - or at least shielded - to reduce the risk of the magnets being vaporized by the vapor deposition source, which would increase the cleaning effort during service. Here, it has been proven to be particularly advantageous if the protection means is made of a non-conductive material, i.e. the protection means merely forms a shield to protect against parasitic coating without limiting or influencing the magnetic effect of the magnetic field generator. In a preferred embodiment the tubing is sealed against vacuum and designed to resist the pumping out of the chamber. This facilitates the generation of vacuum inside the vacuum chamber between different coating sessions.

As used herein, the terms "have", "comprise" or "include" or any arbitrary grammatical variation thereof are used in a non-exclusive way. Thus, these terms may refer to both a situation in which, besides the feature introduced by these terms, no further features are present in the entity described in this context and to a situation in which one or more further features are present. As an example, the expressions "A has B", "A comprises B" and "A includes B" may both refer to a situation in which, besides B, no other element is present in A (i.e. a situation in which A solely and exclusively consists of B) and to a situation in which, besides B, one or more further elements are present in entity A, such as element C, elements C and D or even further elements.

As further used herein, the terms "preferably", "more preferably", "particularly", "more particularly", or similar terms are used in conjunction with optional features, without restricting alternative possibilities. Thus, features introduced by these terms are optional features and are not intended to restrict the scope of the claims in any way. The invention may, as the skilled person will recognize, be performed by using alternative features. Similarly, features introduced by "in an embodiment of the invention" or similar expressions are intended to be optional features, without any restriction regarding alternative embodiments of the invention, without any restrictions regarding the scope of the invention and without any restriction regarding the possibility of combining the features introduced in this way with other features of the invention.

Further optional features and embodiments of the present invention are disclosed in more detail in the subsequent description of preferred embodiments, preferably in conjunction with the dependent claims. Therein, the respective optional features may be realized in an isolated fashion as well as in any arbitrary feasible combination, as the skilled person will realize. It is emphasized here that the scope of the invention is not restricted by the preferred embodiments. In the Figures:
- Fig. 1: schematically illustrates a coating device with a device for turning spectacle lenses according to the state of the art,
- Fig. 2: schematically illustrates a coating device with a device for turning spectacle lenses according to the invention,
- Fig. 3: illustrates in a detail view an embodiment of a turning device according to the invention, in which the magnetic field generator comprises a Halbach array formed by a plurality of permanent magnets,
- Fig. 4: illustrates in a detail view another embodiment of the turning device, in which the magnetic field generator comprises a Halbach array formed by a plurality of electromagnets,
- Fig. 5: schematically illustrates the general structure of a Halbach array,
- Fig. 6: schematically illustrates a further embodiment of the turning device, in which the magnetic field generator comprises a single electromagnet, and
- Fig. 7.: shows a flow chart of a method for producing a spectacle lens

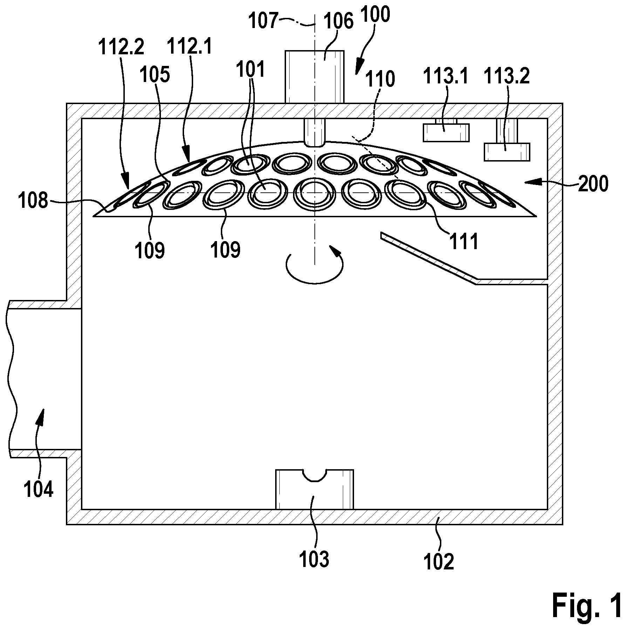

Figure 1 shows a schematic view of a coating apparatus 100 known from the prior art, more precisely from the DE 102006041137 B4, with which spectacle lenses 101 can be coated with functional layers. The coating apparatus 100 comprises a vacuum chamber 102 in which the materials to be applied can be melted and evaporated or sublimated by means of an evaporator source 103. A pump 104, which is only indicated in the figure, is provided for generating the vacuum and can be used to pump out the vacuum chamber 102 in order to generate high-vacuum in the vacuum chamber 102. The spectacle lenses 101, which are to be coated by means of the evaporation source 103, are arranged on a carrier 105, which has a calotte shape and is coupled to a motor 106 to be rotatable about an axis of rotation 107 in the vacuum chamber 102. The carrier 105 has a large number of openings 108 in which lens holders 109 are arranged into which the spectacle lenses 101 to be coated can be inserted and mounted. The openings 108 and thus also the lens holders 109 with the spectacle lenses 101 accommodated therein are arranged in concentric wreaths 112.1, 112.2 having different diameters. Since only one side of the spectacle lenses 101 facing the evaporation source 103 can be coated, it is necessary to turn the spectacle lenses 101 during the coating process by means of a turning device 200. In order to be able to turn the spectacle lenses 101 mounted in the lens holders 109 without ventilating and opening the vacuum chamber 102, the lens holders 109 are mounted in the respective opening 108 in such a way that they are turnable about a pivot axis 110. To provide the required force for turning the lens holder 109 together with the spectacle lenses 101 mounted therein, a magnetic field is provided which acts on a ferromagnetic part 111 of the lens holder 109. For this purpose, in the coating apparatus 100 known from the prior art, each concentric wreath 112.1, 112.2 is assigned its own magnetic field generator 113.1 and 113.2. If the carrier 105 is rotated about the axis of rotation 107 a magnetic force is induced in the ferromagnetic part 111 of the lens holders 109 - when the magnetic field generators 113.1 and 113.2 are switched on - which leads to an automated turning of the lens holder 109, which is pivotably mounted on the carrier 105, when the respective lens holder 109 is located under the magnetic field generator 113.1 or 113.2 which is assigned to the corresponding wreath 112.1 or 112.2.

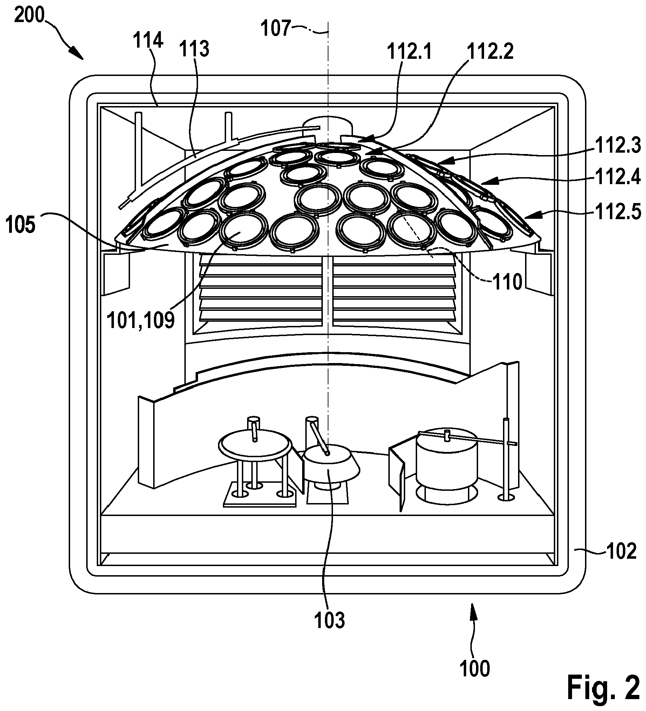

In contrast to the embodiment of the coating apparatus 100 already known from the prior art, in which ultimately only two wreaths 112.1, 112.2 of lens holders 109 are provided, each of which is assigned its own magnetic field generator 113.1 and 113.2, the embodiment of the coating apparatus 100 according to the invention shown in Figure 2 shows a carrier 105 in which the lens holders 109 of the spectacle lenses 101 to be coated are arranged in a total of five concentric wreath 112.1 - 112.5, each having a different diameter. Due to the dome or calotte shape of the carrier 105, the distances of the individual wreath 112.1 - 112.5 to the axis of rotation 107 of the carrier 105 are different. The numbering of the wreaths 112 is ascending with increasing radius, so that in the embodiment shown in Figure 2, in which a total of five wreaths 112 are provided, the wreath 112.1 with the smallest diameter is assigned the designation "first Wreath" and the wreath 112.5 with the largest diameter in this exemplary embodiment is designated "fifth Wreath". Figure 2 shows a schematic representation of a magnetic field generator 113, the specific design of which will be explained in more detail with reference to the Figures below. In the present embodiment only a single magnetic field generator 113 is provided which is responsible for turning the lens holders 109 arranged on all wreath 112.1 to 112.5. The magnetic field generator 113 is mounted or fixed on a ceiling 114 of the vacuum chamber 102 and ultimately follows the shape of the calotte shaped carrier 105. As already described with regard to Figure 1 depicting the coating apparatus 100 known from the prior art, the device 200 for turning the spectacle lenses 101 in the coating apparatus 100 comprises the carrier 105 which is rotatably mounted about the axis of rotation 107. To facilitate the loading and unloading of the spectacle lenses 101 to and from the carrier 105 outside the vacuum chamber 102, the carrier 105 is segmented, which allows the operator to mount and dismount one segment of the carrier 105 at a time to load and unload the spectacle lenses 101 during the coating process. The plurality of lens holders 109 are arranged on wreaths 112.1 to 112.5 of different diameters in order to hold the spectacle lenses 101 to be coated. The lens holders 109 themselves are also mounted in the openings 108 of the carrier 105 such that they can be turned about their respective pivot axis 110 by means of a magnetic force generated by the magnetic field generator 113. In the embodiment of Figure 2 the magnetic field generator 113 is configured such that the resulting magnetic field 117 generated by the magnetic field generator 113 is substantially constant over at least two adjacent wreaths 112. In the present embodiment, the magnetic field generator 113 has a form and shape such that the magnetic field generator 113 extends over all wreaths 112.1 to 112.5.

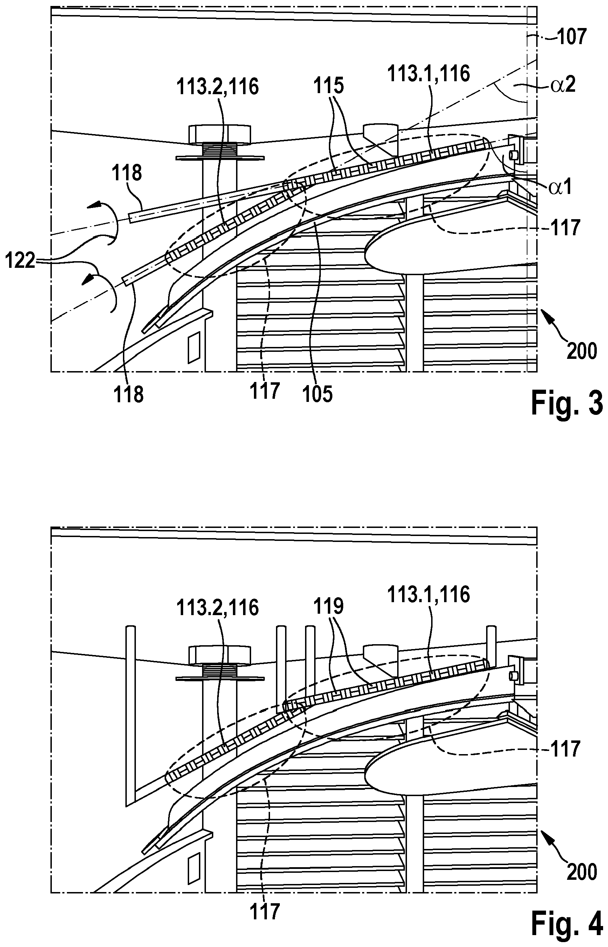

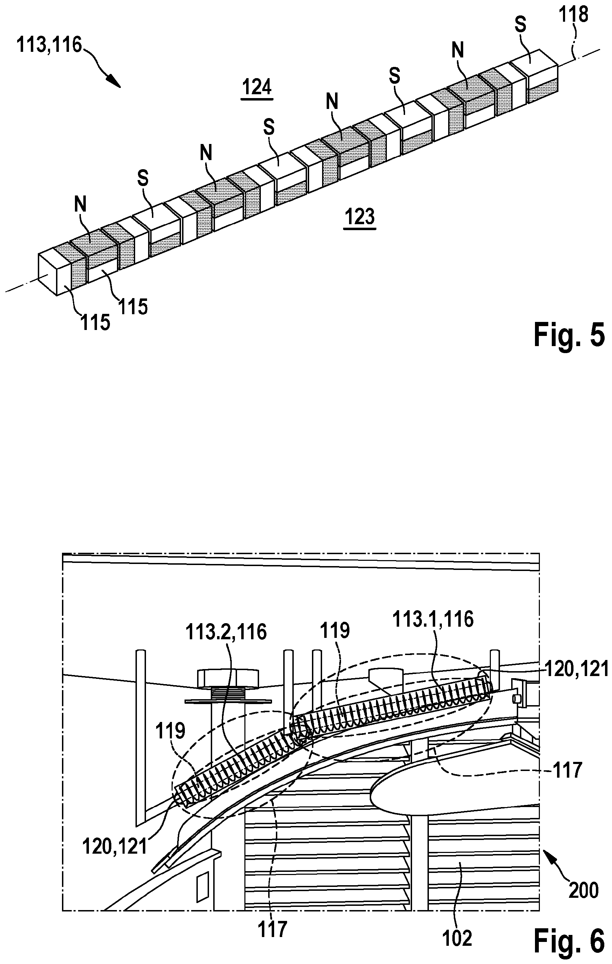

Figure 3 shows a schematic view of an embodiment of the device 200 for turning spectacle lenses 101. In this embodiment, in total two magnetic field generators 113.1, 113.2 are provided, each of which comprises a plurality of permanent magnets 115 arranged in the form of a Halbach array 116. As will be explained below with reference to Figure 5, the Halbach array 116 is characterized by a special arrangement of the individual permanent magnets 115, as described above, by means of which a directional magnetic field 117 is generated, as indicated in Figure 3 by the field lines. The arrangement of the permanent magnets 115 causes an amplification or enhancement of the field lines on one side of the Halbach array 116, which in the present configuration displayed in Figure 3 points downwards, while the field lines are weakened on the other side of the Halbach array 116 and partially cancel each other out. In the embodiment shown in Figure 3, the two magnetic field generators 113.1 and 113.2 are arranged such that a first magnetic field generator 113.1 covers the first wreath 112.1, the second wreath 112.2 and the third wreath 112.3, while the second magnetic field generator 113.2 covers the fourth wreath 112.4 and the fifth wreath 112.5. As the magnetic field generators 113.1, 113.2 are straight the distances between the magnetic field generators 113.1, 113.2 and the respective wreaths 112.1 to 112.3 and 112.4 to 112.5 will not be uniform but increases as the diameter of the wreaths 112.1 to 112.5 increases or with higher number of the respective wreath 112.1 to 112.5. Still, the magnetic field generators 113.1, 113.2 ultimately follow the shape of the carrier 105, so that the longitudinal axis 118 of the two magnetic field generators 113.1, 113.2 have different angles α1, α2 to the axis of rotation 107 of the carrier 105. In the present embodiment displayed in Figure 3 α1, which is the angle between longitudinal axis 118 of the first magnetic field generator 113.1 and the axis of rotation 107 of the carrier 105, is around 80° and α2, which is the angle between the longitudinal axis 118 of the second magnetic field generator 113.2 and the axis of rotation 107 of the carrier 105 is around 60°. To be able to control the effect of the magnetic field 117 provided by the magnetic field generators 113.1 and 113.2 on the lens holders 109, in the embodiment of Figure 3 the magnetic field generators 113.1, 113.2, are each arranged so that they can be pivoted about the longitudinal axis 118 by at least an angle of 120°, as indicated by arrows 122. This allows the amplified or enhanced field lines of the magnetic field generator 113 to ultimately be rotated away from the lens holders 109, whereby the magnetic force applied to the lens holder 109 can ultimately be switched on and off. This provides a simple way to prevent the lens holders 109 from being inadvertently flipped. The adjustment of the Halbach arrays 116 between the "on"-position and "off"-position is only indicated and can be carried out from outside the vacuum chamber 102, for example by means of rotary feedthroughs. In addition, this adjustment can be either motor-assisted or be performed manually. Preferably, this adjustment is carried out automatically. Thus, during the actual coating of the first side of the spectacle lenses 101, it is possible to rotate the first side of the Halbach arrays 116, where the magnetic field 117 is enhanced, away from the spectacle lenses 101 until the coating of the first side of the spectacle lenses 101 is completed. In this configuration the magnetic field generators 113.1, 113.2 are considered to be in an "off"-position, which means that their influence on the lens holders 109 is inhibited and an unintentional turning or flipping of the lens holders 109 is prevented. Then the Halbach arrays 116 can be rotated again about the longitudinal axis 118 so that their enhanced or amplified magnetic fields 117 face the lens holders 109 and the spectacle lenses 101 mounted therein. In this configuration the magnetic field generators 113.1, 113.2 are considered to be in an "on"-position, in which the lens holders 109 can be turned by applying a magnetic force onto the ferromagnetic part 111 of the lens holders 109. Once the turning of the lens holders 109 and the spectacle lenses 101 mounted therein is complete, the magnetic field generators 113.1, 113.2 can then be pivoted away from the lens holders 109 again by 120°. In this configuration the enhanced magnetic fields 117 face away from the lens holders 109 and, thus, an unintentional turning of the spectacle lenses 101 is again effectively prohibited. In a preferred embodiment the "on" and "off' positions of the magnetic field generators 113.1, 113.2 are each defined by a stop.

In the exemplary embodiment of the device 200 for turning spectacle lenses 101 shown in Figure 4, also two magnetic field generators 113.1, 113.2 are provided. These are also designed as Halbach arrays 116, whereby this alternative embodiment has a plurality of electromagnets 119. The electromagnets 119 are switchable between a first state for generating the magnetic force, i.e. the "on"-position, and a second state in which the magnetic field generators 113.1, 113.2 are deactivated, i.e. the "off"-position. Analogous to the embodiment described above with reference to Figure 3, where the Halbach arrays 116 consisted of permanent magnets 115, the magnetic field generator 113.1, 113.2 shown in Figure 4 also have a directed magnetic field 117 in which the magnetic field 117 is amplified or enhanced on one side of the magnetic field generator 113.1, 113.2 and weakened on the other side, thus ultimately generating a directional magnetic field 117 oriented in the direction of the wreaths 112.1 to 112.5. By using the electromagnets 119, it is also possible to easily switch the electromagnets 119 on and off. Thus, during the actual coating process, the magnetic field generators 113.1, 113.2 can be deactivated and only switched on when the coating of the first side of the spectacle lenses 101 is completed, in order to turn the spectacle lenses 101 mounted in the lens holders 109 before coating the second side of the spectacle lenses 101. Hence, also with the alternative embodiment of the Halbach array 116 comprising electromagnets 119 it is possible to switch the magnetic field 117 applied to the respective lens holders 109 of the respective wreaths 112 "on" or "off' as desired.

Figure 5 shows a schematic view of the structure of a magnetic field generator 113 which can be used in a device 200 for turning spectacle lenses 101 according to the invention. The magnetic field generator 113 is formed as a Halbach array 116, which in the displayed example consists of a plurality of permanent magnets 115. Neighboring permanent magnets 115 are each tilted 90° in the direction of the longitudinal axis 118 of the magnetic field generator 113, whereby ultimately a directed magnetic field 117 can be generated. Thus, the field lines on a first, weak side 123 of the Halbach array 116 cancel each other out, which weakens the magnetic field 117 and thus the applicable magnetic force on this side. On a second strong side 124 of the Halbach array 116, however, the field lines are enhanced, so that the resulting magnetic force, which can be generated by the magnetic field generator 113 in the respective lens holder 109, is amplified or enhanced. Thus, a directional magnetic field 117 is ultimately created, which can be used to flip the spectacle lenses 101 together with the lens holders 109, in which they are mounted.

Figure 6 shows a further embodiment of a turning device 200 according to the invention. In this embodiment, as already described with reference to the embodiments according to Figures 3 and 4, two magnetic field generators 113.1, 113.2 are provided, which are arranged following the shape of the carrier 105. In other words, the magnetic field generator 113.1, arranged above the first wreath 112.1, the second wreath 112.2 and the third wreath 112.3 has a larger angle to the axis of rotation 107 of the carrier 105 than the magnetic field generator 113.2 arranged above the fourth wreaths 112.4 and the fifth wreath 112.5. In this embodiment, the magnetic field generators 113.1, 113.2 each comprises a single electromagnet 119 which has an elongated, straight shape and provides a homogenous magnetic field 117. As further indicated in Figure 6, the electromagnets 119 are surrounded by a protection means 120 which, in the displayed embodiment, is formed by a closed tube 121 which is ultimately sealed off from the vacuum prevailing in the surrounding vacuum chamber 102. Alternatively, however, the protection means 120 may merely consist of a shielding which does not allow any encapsulation with respect to the vacuum prevailing in the vacuum chamber 102 and which is merely intended to ensure that unintentional coating of the magnetic field generators 113.1, 113.2 by the evaporation source 103 is prevented.

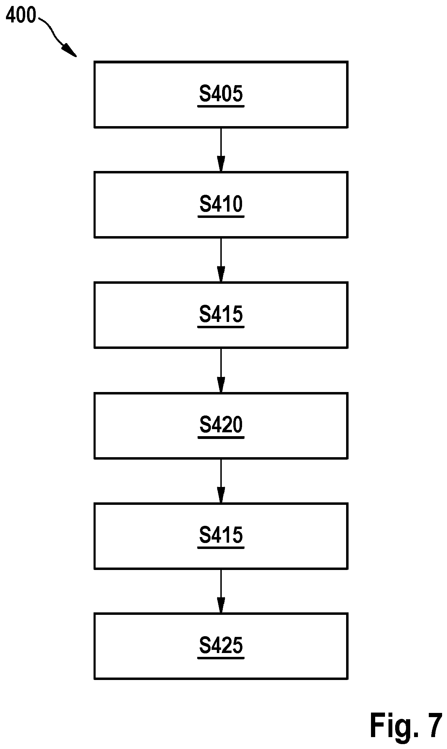

With reference to Figure 7 a method 400 for producing a spectacle lens 101 is presented.

The method comprises a step S405 of providing at least one spectacle lens 101, preferably a plurality of spectacle lenses 101, which might have been already subject to other manufacturing steps such as a shaping step or other surface treatment steps, for applying e.g., a hard coating. The method 400 further comprises a step S410 in which the at least on spectacle lens 101, preferably the multiple of spectacle lenses 101, are mounted on lens holders 109 positioned on a carrier 105, which is part of a coating apparatus 100 as described above with regard to Figure 2. To facilitate the mounting step S410 the carrier 105 might be divided into several parts or segments which can be individually removed from the coating apparatus 100 by the operator to load the spectacle lens(es) 101 into the lens holders 109 mounted thereon. The carrier 105 has a calotte shape and one side of each of the spectacle lenses 101 mounted on the carrier 105 are oriented to a common point where the evaporation source 103 is located. The lens holders 109 and the spectacle lenses 101 mounted therein are arranged in concentric wreaths 120 of different diameters on the carrier 105 of the coating apparatus 100. In a coating step S415 the sides of the spectacle lenses 101 pointing towards the evaporation source 103 are coated with at least one layer (or sublayer) of coating. The method 400 further comprises a step S420 of turning the spectacle lenses 101 by means of a magnetic force generated by a magnetic field generator 113. This turning step 420 of the lens holders 109 and the respective spectacle lenses 101 is carried out after the coating step 415, in which the sides of the spectacle lenses 101 facing the evaporation source 103 are coated. The magnetic field generator 113.1, 113.2 generates a magnetic field 117, which is substantially constant over at least two adjacent wreaths 112. For applying the magnetic force on the lens holders 109, the lens holders 109 comprise a ferromagnetic part 111 interacting with the magnetic field generator 113 when the carrier 105 is rotated about it axis of ration during the turning step. Subsequently another coating step 415 is carried out on the side of the spectacle lenses 101, which have not yet been coated. In a subsequent step S425 the coated spectacle lenses 101 are processed further, by removing them from the vacuum chamber 102 of the coating apparatus 100 and applying further production steps to them such as cutting them to their final size.

### List of reference signs

- 100: coating apparatus
- 101: spectacle lens
- 102: vacuum chamber
- 103: evaporation source
- 104: pump
- 105: carrier
- 106: motor
- 107: axis of rotation
- 108: opening
- 109: lens holder
- 110: pivot axis
- 111: ferromagnetic part
- 112, 112.1 - 112.5: wreath with different diameter
- 113, 113.1 - 113.2: magnetic field generator
- 114: ceiling
- 115: permanent magnet
- 116: Halbach Array
- 117: magnetic field
- 118: longitudinal axis
- 119: electromagnet
- 120: protection means
- 121: tube
- 122: arrow
- 123: weak side
- 124: strong side
- 200: turning device
- 400: production method
- S405 - S425: method steps
- α: angle

## Claims

1. Device (200) for turning spectacle lenses (101) in a coating apparatus (100), comprising a carrier (105) which is rotatably mounted about a axis of rotation (107) and on which a plurality of lens holders (109) are arranged on concentric wreaths (112) of different diameters in order to hold the spectacle lenses (101)to be coated, wherein the lens holders (109) are mounted such that they can be turned about a pivot axis (110) by means of a magnetic force generated by a magnetic field generator (113), **characterized in that** the magnetic field generator (113) is configured such that the magnetic field (117) generated by the magnetic field generator (113) is substantially constant over at least two adjacent wreath (112).

2. Device (200) according to claim 1, **characterized in that** the resulting magnetic force applied to the spectacle lens holders (109) is between 0.001 N and 0.025 N.

3. Device (200) according to any one of the preceding claims, **characterized in that** the shape of the magnetic field generator (113) is adapted to the shape of the carrier (105).

4. Device (200) according to any one of the preceding claims, **characterized in that** the magnetic field generator (113) has a shape such that the magnetic field generator (113) extends over at least two of the concentric wraths (112).

5. Device (200) according to any one of the preceding claims, **characterized in that** the magnetic field generator (113) comprises a Halbach array (116).

6. Device (200) according to claim 5, **characterized in that** the Halbach array (116) comprises a plurality of permanent magnets (115).

7. Device (200) according to claim 6, **characterized in that** the permanent magnets (115) of the Halbach array (116) are pivotable around a longitudinal axis (118) of the magnetic field generator (113) by at least 120°.

8. Device (200) according to claim 5, **characterized in that** the Halbach array (116) is formed of a plurality of electromagnets (119) and is switchable between a first state generating the magnetic field (117) and a second state in which the magnetic field generator (113) is deactivated.

9. Device (200) according to any one of the preceding claims, **characterized in that** the angle between the magnetic field generator (113) and the axis of rotation (107) is greater than 40°, preferably greater than 45°.

10. Device (200) according to one of the preceding claims, **characterized in that** at least two magnetic field generators (113) are provided.

11. Device (200) according to one of the preceding claims, **characterized in that** a protection means (120) for covering the magnetic field generator (113) at least partly is provided selected from a group comprising a shielding and a tubing (121).

12. Method (400) for producing a spectacle lens (101) comprising the following step:
- Turning (420) the spectacle lens (101) mounted in one of a multiple of lens holders (109) arranged in concentric wreaths (112) of different diameters on a carrier (105) of a coating apparatus (100) by means of a magnetic force generated by a magnetic field generator (113);
**characterized in that**
the magnetic field generator (113) generates a magnetic field (117), which is substantially constant over at least two adjacent wreaths (112).
